# EUROPÄISCHE PATENTSCHRIFT

(11) **EP 1 874 976 B1**
(45) Veröffentlichungstag und Bekanntmachung des Hinweises auf die Patenterteilung: **13.03.2013**
(21) Anmeldenummer: 06723624.0
(22) Anmeldetag: 22.03.2006
(51) Int. Cl.: C23C 14/24, C23C 14/12, C23C 14/26

(54) **VERFAHREN ZUR VERDAMPFUNG ODER SUBLIMATION VON BESCHICHTUNGSMATERIALIEN**
METHOD FOR EVAPORATION OR SUBLIMATION OF COATING MATERIALS
PROCEDE POUR METTRE EN OEUVRE LA VAPORISATION OU LA SUBLIMATION DE MATIERES DE REVETEMENT

(30) Priorität: 24.03.2005 DE 102005013875
(43) Veröffentlichungstag der Anmeldung: 09.01.2008
(73) Patentinhaber: CreaPhys GmbH, 01139 Dresden (DE)
(72) Erfinder: FRÖB, Hartmut, 01768 Reinhardtsgrimma (DE); DRECHSEL, Jens, 01768 Reinhardtsgrimma (DE)
(74) Vertreter: Hertz, Oliver
(86) Internationale Anmeldenummer: PCT/EP2006/002632
(87) Internationale Veröffentlichungsnummer: WO 2006/100058

(56) Entgegenhaltungen:
- EP-A- 0 561 016
- EP-A- 1 167 566
- EP-A- 1 418 250
- JP-A- 10 330 920
- US-A1- 2004 115 338
- PATENT ABSTRACTS OF JAPAN Bd. 007, Nr. 252 (C-194), 9. November 1983 (1983-11-09) -& JP 58 136773 A (TOKYO SHIBAURA DENKI KK), 13. August 1983 (1983-08-13)

## Beschreibung

Die Erfindung betrifft ein Verfahren zur Verdampfung oder Sublimation von Materialien, insbesondere für Beschichtungszwecke. Es werden auch eine Heizeinrichtung, mit der Material durch Verdampfung oder Sublimation in die Gasphase überführbar ist, zum Beispiel zur Verwendung in einer Beschichtungsanlage, und insbesondere eine Heizeinrichtung für einen Verdampfer, sowie eine Beschichtungsanlage beschrieben, die mit mindestens einer derartigen Heizeinrichtung ausgestattet ist.

Die Beschichtung mittels thermischer Verdampfung ist seit Jahrzehnten allgemein bekannt. Die Einfachheit der thermischen Verdampfung ist ein wesentlicher Grund für deren weite Verbreitung im Bereich der Beschichtungsverfahren, insbesondere bei der Herstellung organischer Opto-Elektronik, wie z. B. Displays auf der Basis organischer Leuchtdioden (OLED).

Bei der thermischen Verdampfung wird das zu verdampfende Material in einem Verdampfer derart erhitzt, dass es in den gasförmigen Zustand übergeht (Verdampfung oder Sublimation). Anschließend wandern die Materialteilchen (u. a. Moleküle) aufgrund ihrer erhaltenen kinetischen Energie oder durch Diffusionsprozesse (z.B. in einem Trägergas) zur vorgesehenen Abscheidefläche, wo sie dann kondensieren. Typischerweise findet die Verdampfung unter Vakuumbedingungen statt, jedoch sind auch Verdampfungen unter reduziertem Druck oder sogar bei Atmosphärendruck mittels inertem Trägergas möglich.

Aus der Praxis sind viele Techniken zur Überführung des Materials in die Gasphase bekannt. In einer einfachen Form wird das zu verdampfende Material in einen Tiegel eingebracht, der mit einem Heizelement (Filament) umgeben ist. Bei der Erwärmung des Tiegels wird das Material durch Wärmestrahlung und/oder Wärmeleitung erwärmt und so die erforderliche Energie bis zum Übergang in die Gasphase zugeführt.

Verdampfer für die Beschichtungstechnik sind oft so ausgelegt, dass möglichst viel Material in möglichst kurzer Zeit, aber unter stabilen Bedingungen abgeschieden wird. Dabei soll das Material durch die Einstellung einer möglichst niedrigen Temperatur des Verdampfers thermisch nur gering belastet werden. Diese Anforderung ist besonders für organische Materialien relevant, da diese unter zu hohem Energieeintrag zur Umbildung oder Zerstörung neigen. Die Stabilität des Materials muss aber auch bei anorganischen Verbindungen beachtet werden.

Um den genannten Anforderungen gerecht zu werden, wurde vorgeschlagen, den Energieeintrag in das zu verdampfende Material homogen zu gestalten. In EP 1 132 493 A2 wird für die Verdampfung organischer Moleküle zur Beschichtung von Substraten vorgeschlagen, das zu verdampfende Material in einem Tiegel mit Partikeln aus Metall oder Keramik zu vermengen, die eine hohe Wärmeleitung besitzen. Trotz des verbesserten Wärmeleitungsverhaltens durch den Zusatz der Metall- oder Keramikpartikel besteht der Nachteil, dass der Energieeintrag in den Tiegel nur indirekt erfolgt. Der Energietransport durch die Partikel ist nur unzureichend, da er an den Kontaktstellen zwischen den Partikeln durch das zu verdampfende Material reduziert wird. Ein weiterer Nachteil kann darin bestehen, dass sich durch die lose Anordnung im Tiegel die Abstrahlcharakteristik des Verdampfers mit variiertem Füllzustand ändert. Dies hat negative Einflüsse auf die Beschichtungshomogenität und die Prozesssteuerung. Zudem ist die Form des Tiegels und somit auch die Form des Molekülstrahls eingeschränkt.

Aus EP 0 561 016 A1 ist bekannt, organische Schichten z. B. aus Wachsen oder Urethanen herzustellen, indem zunächst ein poröser Träger mit einer Schmelze oder Lösung eines organischen Materials imprägniert und anschließend der Träger in einem thermischen Verdampfer erwärmt wird, um das organische Material zu verdampfen. Da die Aufnahmefähigkeit des Trägers bekannt ist, ermöglicht diese Technik ein quantitatives Verdampfen vorbestimmter Materialmengen. Die Verwendung der Träger besitzt jedoch eine Reihe von Nachteilen, so dass diese herkömmliche Technik zur Erfüllung der o. g. Anforderungen nur beschränkt geeignet ist. Ein erster Nachteil besteht in der indirekten Erwärmung der imprägnierten Träger in einem Verdampfertiegel. Der Wärmeeintrag aus einer externen Quelle ist inhomogen, so dass eine ungleichmäßige Verdampfung und daher eine ungleichmäßige Beschichtung resultieren. Um diesem Problem zu begegnen, werden bei der herkömmlichen Technik als Träger poröse Partikel oder dünne Plättchen verwendet. Die Partikel besitzen den o. g. Nachteil eines verschlechterten Wärmeübergangs. Die Plättchenform stellt eine unerwünschte Beschränkung der verdampfbaren Materialmenge und/oder der Verdampfergeometrie dar. Ein weiterer Nachteil besteht darin, dass mit den herkömmlichen Trägern, die für eine Beladung durch ein Imprägnieren ausgelegt sind, eine vollständige Beseitigung ggf. vorhandener Lösungsmittel nicht sichergestellt werden kann. Bei zahlreichen Anwendungen ist die Präsenz von Lösungsmitteln während des Verdampfungsvorgangs jedoch problematisch, da die Lösungsmittel als Verunreinigungen die Schichtbildung und Schichteigenschaften stören. Dies kann bei der Herstellung insbesondere von organischen, opto-elektronischen Bauelementen zur Verringerung der Effizienz oder der Lebensdauer führen.

Weitere Heizeinrichtungen für die Verdampfung von Verdampfungsgut sind aus EP 1 418 250 A2, US 2004/0115338 A1, EP 1 167 566 A1 und JP 58-136773 bekannt.

Die Aufgabe der Erfindung ist es, ein verbessertes Verdampfungs- oder Sublimationsverfahren, insbesondere für Beschichtungsanlagen bereitzustellen, mit dem die Nachteile der herkömmlichen Verdampfungstechniken überwunden werden und das einen erweiterten Anwendungsbereich, insbesondere bei der Herstellung von Schichten mit organischen Materialien besitzt. Mit demr Verfahren sollen insbesondere eine hohe Beschichtungsleistung (hoher Materialaustrag pro Zeiteinheit), eine homogene Schichtbildung auch bei ausgedehnten Substraten und/oder eine schonende und genaue Temperatureinstellung bei der Erwärmung des zu verdampfenden Materials erreicht werden.

Diese Aufgabe wird durch ein Beschichtungsverfahren mit den Merkmalen der unabhängigen Ansprüche gelöst. Vorteilhafte Ausführungsformen und Anwendungen der Erfindung ergeben sich aus den abhängigen Ansprüchen.

Gemäß der Erfindung wird die o. g. Aufgabe insbesondere durch ein Verdampfungsverfahren gelöst, bei dem mindestens ein Heizkörper mit dem zu verdampfenden Material beladen und die Heizelemente des mindestens einen Heizkörpers zur direkten Erwärmung des zu verdampfenden Materials in Betrieb gesetzt werden.

Vorteilhafterweise zeichnet sich das erfindungsgemäße Verfahren durch eine kurze Reaktionszeit bei der Temperatureinstellung im zu verdampfenden Material aus. Die Temperatur in der Heizeinrichtung kann mit größerer Genauigkeit eingestellt werden, so dass eine schonende Verdampfung bei hohen Verdampfungsraten ermöglicht wird.

Es wird eine Heizeinrichtung zur Erwärmung von zu verdampfendem Material (im folgenden: Beschichtungsmaterial) und dessen Überführung in die Gasphase beschrieben, wobei die Heizeinrichtung insbesondere einen Heizkörper mit einem inneren Volumen aufweist, das zur Aufnahme des Beschichtungsmaterials ausgelegt ist und eine Vielzahl von verteilt angeordneten Heizelementen enthält. Im Gegensatz zu den herkömmlichen Verdampfungstechniken wird mit der Heizeinrichtung ein enger direkter Kontakt zwischen dem Beschichtungsmaterial und dem Heizkörper und damit ein unmittelbarer Energieübergang in das Beschichtungsmaterial gewährleistet. Durch die Verteilung der Heizelemente im Volumen des Heizkörpers wird die wirksame Kontaktfläche zwischen dem Beschichtungsmaterial und den Heizelementen wesentlich vergrößert. Der Energieübergang wird gleichzeitig in allen Teilen der zu verdampfenden Materialmenge erreicht, so dass vorteilhafterweise eine vorbestimmte, z. B. gleichförmige Verteilung des in der Gas- oder Dampfphase austretenden Materials bereitgestellt wird. Ein wichtiger Vorteil des Heizkörpers besteht somit in der Temperaturhomogenität innerhalb von dessen Volumen. Durch die Verteilung der Heizelemente werden lokal überhitzte Stellen ("Hotspots") vermieden und damit die Gefahr eines lokalen Zerfalles des Beschichtungsmaterials durch übermäßigen Wärmeeintrag vermindert. Mit der Heizeinrichtung wird das Beschichtungsmaterial vorteilhafterweise direkt erwärmt, so dass eine übermäßige thermische Belastung des Beschichtungsmaterials vermieden, die zum Erreichen vorgegebener Beschichtungsraten erforderlichen Verdampfungstemperaturen reduziert und generell eine effiziente Verdampfung erreicht werden können.

Die innere Struktur des Heizkörpers sorgt aufgrund ständiger Adsorption und Desorption der zu verdampfenden Materialien im Volumen für einen homogen Materialfluss an der Oberfläche des Heizkörpers und damit für eine gleichmäßige Beschichtung. Dadurch wird ferner sichergestellt, dass die Verdampfungscharakteristik auch unter verschiedensten Füllständen der Heizeinrichtung konstant bleibt oder sich nur vernachlässigbar wenig ändert.

Vorteilhafterweise bestehen bei der Anwendung der Heizeinrichtung keine Beschränkungen in Bezug auf die Art des zu verdampfenden Beschichtungsmaterials, das je nach konkreter Anwendung ausgehend von einem flüssigen oder festen Startzustand atomar, molekular oder aggregiert in die Gasphase überführt werden soll. Die Überführung in die Gasphase umfasst typischerweise eine Verdampfung oder Sublimation, wobei hier für alle Arten des Phasenübergangs der Begriff "Verdampfung" verwendet wird.

Der Begriff "Heizelement" umfasst hier jede im Heizkörper vorgesehene Komponente, die zur direkten Erwärmung angrenzend angeordneten Beschichtungsmaterials geeignet ist. Mit einem Heizelement ist die Temperatur des angrenzenden Beschichtungsmaterials entsprechend der Betriebseinstellung einer Wärmequelle unmittelbar einstellbar. Zu diesem Zweck stellen die Heizelemente als solche die Wärmequelle oder Teile der Wärmequelle dar.

Wenn die Heizelemente fest in den Heizkörper eingebettet sind, kann eine vorbestimmte Verteilung der Heizelemente realisiert werden. Beispielsweise können die Heizelemente für eine homogene Abstrahlcharakteristik im Volumen des Heizkörpers gleichförmig verteilt sein. In Abhängigkeit von der konkreten Anwendung kann alternativ eine ungleichförmige Verteilung der Heizelemente vorgesehen sein, um in verschiedenen Teilbereichen des Heizkörpers verschiedene Verdampfungsraten zu erzielen.

Allgemein können die Heizelemente als separate Bauteile im Heizkörper fixiert sein. Bevorzugt ist jedoch eine Variante, bei der die Heizelemente und der Heizkörper aus einem gemeinsamen Material gebildet sind. Die Innenwände des Heizkörpers werden als Heizelemente verwendet. Diese Variante besitzt den Vorteil, dass die Heizelemente gleichzeitig als Träger für das Beschichtungsmaterial dienen. Vorteilhafterweise werden der Wärmeübergang verbessert und zusätzliche Trägermaterialien vermieden, die das Ansprechverhalten bei der Temperatureinstellung mit der Heizeinrichtung verschlechtern könnten.

Vorzugsweise bestehen die Heizelemente aus einem Material oder einer Materialzusammensetzung mit einer Wärmeleitfähigkeit von mindestens 2 W/m·K. Vorteilhafterweise wird dadurch eine schnelle Temperatureinstellung im gesamten Volumen des Heizkörpers erzielt. Besonders bevorzugt sind Heizelemente mit einer Wärmeleitfähigkeit oberhalb von 10 W/m·K.

Gemäß einer vorteilhaften Variante der Erfindung sind die Heizelemente zum aktiven Heizen des Beschichtungsmaterials ausgelegt. In diesem Fall werden die Heizelemente direkt mit einem elektrischen Strom beaufschlagt, um unmittelbar elektrische Energie in thermische Energie umzuwandeln. Diese Ausführungsform der Erfindung besitzt besondere Vorteile in Bezug auf ein schnelles Ansprechverhalten der Heizeinrichtung. Die Heizelemente können zum Beispiel direkt mit mindestens einer Stromquelle verbunden sein. Alternativ können aktiv arbeitenden Heizelemente Induktionselemente sein, in denen durch eine äußere elektromagnetische Einwirkung ein Stromfluss induziert wird.

Gemäß einer zweiten Variante sind die Heizelemente für ein passives Heizen des Beschichtungsmaterials ausgelegt und hierzu direkt mit mindestens einer Wärmequelle verbunden. Diese Ausführungsform ermöglicht vorteilhafterweise einen vereinfachten Aufbau der Heizeinrichtung und eine flexiblere Anpassung an konkrete Verdampfungsaufgaben. Bei der Bereitstellung von passiven Heizelementen wird zur Erzielung eines schnellen Ansprechverhaltens eine erhöhte Wärmeleitfähigkeit der Heizelemente oberhalb von 50 W/m·K bevorzugt.

Allgemein weist der Heizkörper eine dreidimensionale innere Struktur auf, durch die Hohlräume und eine innere Oberfläche gebildet werden. Vorteilhafterweise bestehen keine Beschränkungen in Bezug auf die Form der inneren Struktur. Die Struktur kann insbesondere in Abhängigkeit vom Phasenverhalten (flüssig, fest) des Beschichtungsmaterials, der zu verdampfenden Materialmenge und/oder der gewünschten Formgebung des Heizkörpers gewählt werden. Gemäß der Erfindung wird ein Heizkörper verwendet, bei dem die inneren Hohlräume durch offenporigen Schaum gebildet werden.

Vorzugsweise besteht der Heizkörper aus mindestens einem elektrisch leitfähigen Material, wie zum Beispiel mindestens einem Metall und/oder mindestens einer Keramik. Diese Materialien besitzen Vorteile in Bezug auf die mechanische und thermische Stabilität und die Bearbeitbarkeit zur Bereitstellung bestimmter Außenformen des Heizkörpers. Als metallische Materialien können bspw. Wolfram, Tantal, Molybdän, Kupfer, Gold, Silber oder Edelstahl (z. B. Edelstahlschaum) verwendet werden. Bevorzugte Keramiken umfassen Siliziumkarbid, Bornitrit, Aluminiumoxid, Bornitrit-Titandiborit und Aluminiumnitrit oder Zusammensetzungen aus diesen. Bei einem Heizkörper aus einer Metall-Keramik-Zusammensetzung kann beispielsweise ein Aufbau mit einer metallbeschichteten Keramik vorgesehen sein. Des Weiteren kann der Heizkörper Graphit enthalten oder vollständig aus Graphit bestehen. Im ersten Fall kann zum Beispiel eine Zusammensetzung mit einer mit Graphit beschichteten Keramik oder mit einer Keramik, in die Graphit eingebettet ist, vorgesehen sein.

Es wird auch eine Heizeinrichtung mit mehreren Heizkörpern beschrieben, die mit einem Beschichtungsmaterial oder verschiedenen Beschichtungsmaterialien beladbar sind. In Abhängigkeit von der konkreten Beschichtungsaufgabe können bspw. Heizkörper, die mit verschiedenen Beschichtungsmaterialien beladen sind und/oder verschiedene innere Strukturen aufweisen, in einer Verdampfereinrichtung nebeneinander angeordnet sein. Des Weiteren kann es von Vorteil sein, wenn mehrere Heizkörper übereinander, z. B. als Stapel angeordnet sind. Vorteilhafterweise kann die Steuerung des Verdampfungsprozesses verbessert werden, wenn die zu mindestens einem der Heizkörper gehörenden Heizelemente getrennt von den übrigen Heizelementen betrieben werden können.

Ein weiterer wichtiger Vorteil der Heizeinrichtung wird erzielt, wenn diese mit einer Lenkeinrichtung zur Formung einer Strahlcharakteristik des verdampften Beschichtungsmaterials ausgestattet ist. Im Gegensatz zur herkömmlichen Tiegelverdampfung, bei der die Strahlcharakteristik durch die Tiegelform, die Temperaturverteilung im Tiegel und das Verhalten des Beschichtungsmaterials bestimmt wird, kann mit dem erfindungsgemäß verwendeten Heizkörper eine definierte Strahlcharakteristik festgelegt werden. Die Lenkeinrichtung kann allgemein durch jede Komponente gebildet werden, die geeignet ist, dem verdampften Material eine bestimmte Bewegungsrichtung zu geben. Die Lenkeinrichtung kann bspw. durch einen Heizkörper mit Heizelementen gebildet werden, der bei Betrieb der Heizeinrichtung nicht mit Beschichtungsmaterial beladen wird, sondern das Beschichtungsmaterial nur hindurchtreten lässt.

Die Lenkeinrichtung besitzt den besonderen Vorteil, dass die Überführung des Beschichtungsmaterials in die Gasphase vom Austritt des verdampften Beschichtungsmaterials in den Innenraum einer Beschichtungsanlage getrennt wird. Die Lenkeinrichtung wirkt als Materialtransportmedium. Der Transport des verdampften Materials durch die Lenkeinrichtung wird durch die ständige Adsorption und Desorption des Beschichtungsmaterials in der inneren Struktur der Lenkeinrichtung ermöglicht. Vorteilhafterweise kann damit der für die Verdampfung vorgesehene Heizkörper in Bezug auf die Funktion der Überführung des Beschichtungsmaterials in die Gasphase optimiert werden, während der zusätzliche Körper der Lenkeinrichtung für die Steuerung des Materialflusses optimiert wird.

Der Heizkörper und/oder die Lenkeinrichtung sind in ihrer äußeren Form vorteilhafterweise entsprechend der gewünschten Verdampfungscharakteristik frei wählbar. Die Oberfläche, durch die das verdampfte Material austritt und die zu einem Substrat hin frei liegt (Austrittsfläche), ist in Abhängigkeit von der konkreten Verdampfungsaufgabe frei wählbar. So können sowohl ebene Flächen homogen beschichtet werden, aber auch vielfältig gekrümmte, konkave oder konvexe Flächen. Eine gekrümmte Austrittsfläche kann in Teilbereichen verschieden, insbesondere konkav oder konvex gebildet sein. Ein weiterer Vorteil besteht darin, dass die Verdampfungscharakteristik durch die Formgebung derart beeinflusst wird, dass der Materialfluss während des Verdampfungsprozesses vornehmlich in Richtung des zu bedampfenden Objektes gerichtet ist. Somit wird die Effizienz der Verdampfung gesteigert, welche durch das Verhältnis zwischen der Materialmenge auf dem zu beschichtenden Objekt und dem aufzuwendenden Material im Verdampfersystem bestimmt ist. Die Form der Austrittsfläche wird vorzugsweise in Abhängigkeit von der Form der Oberfläche des zu beschichtenden Substrates gewählt.

Vorteilhafterweise kann die innere Struktur des Heizkörpers in Abhängigkeit von den Bedingungen einer konkreten Verdampfungsaufgabe frei dimensioniert werden. Die Größe der Hohlräume, z. B. der Poren kann in Abhängigkeit von dem Phasenverhalten des Beschichtungsmaterials und der gewünschten Austragsmenge gewählt werden. Für feste Beschichtungsmaterialien, z. B. Materialien in Pulver- oder Partikelform ist es hinsichtlich der Beladung des Heizkörpers und für große Auftragsmengen von Vorteil, die Hohlräume mit einer charakteristischen Größe im Bereich von 1 mm bis 5 cm zu wählen. Diese charakteristische Größe bezieht sich auf wenigstens eine Raumrichtung, wie z. B. den Abstand zwischen benachbarten parallelen Lamellen bei einer Lamellenstruktur oder der Abstand einander gegenüberliegenden Innenwände bei einer Wabenstruktur. Bei bestimmten Anwendungen kann es vorteilhaft sein, die Zwischenräume in der inneren Struktur kleiner zu wählen. Beispielsweise wird zur Verdampfung von Materialien, die bei der Beladung die flüssige Phase aufweisen, die innere Struktur so dimensioniert, dass Kapillarkräfte zur homogenen Einführung und Verteilung des Materials im Heizkörper und damit zu einer gleichmäßigen Verdampfung führen. Entsprechend kann es von Vorteil sein, wenn die Hohlräume des Heizkörpers in mindestens einer Raumrichtung eine charakteristische Größe im Bereich von 1 µm bis 1 mm aufweisen.

Die geeignete Dimensionierung der inneren Struktur kann vom Fachmann in Abhängigkeit von den Verdampfungsbedingungen gewählt werden. So kann eine charakteristische Größe von z. B. 3 cm bei der Bedampfung großflächiger Substrate (mit Dimensionen im dm- bis m-Bereich) geeignet sein.

Es wird auch eine Beschichtungsanlage beschrieben, die mit mindestens einer Heizeinrichtung ausgestattet ist.

Die Beschichtungsanlage weist des Weiteren eine Substrathalterung auf, mit der ein zu beschichtendes Substrat positionierbar ist, so dass dessen Oberfläche entlang einer vorbestimmten Bezugsfläche verläuft. Vorzugsweise sind die Bezugsfläche und die Austrittsfläche der Heizeinrichtung geometrisch ähnlich gebildet.

Gemäß bevorzugten Ausführungsformen der Erfindung werden die Heizelemente des mindestens einen Heizkörpers direkt oder induktiv mit einem elektrischen Strom oder ersatzweise mit einem Wärmestrom beaufschlagt.

Es wird auch die Verwendung einer Heizeinrichtung oder einer Beschichtungsanlage zur Herstellung von Schichten aus organischen Materialien, insbesondere aus organischen Farbstoffen beschrieben.

Weitere Einzelheiten und Vorteile der Erfindung werden im Folgenden unter Bezugnahme auf die beigefügten Zeichnungen beschrieben. Es zeigen:
- Figuren 1 bis 2:: eine Heizeinrichtung mit aktiv betriebenen Heizelementen (keine Ausführungsformen der Erfindung);
- Figur 3:: eine Ausführungsform einer erfindungsgemäß verwendeten Heizeinrichtung mit aktiv betriebenen Heizelementen; und
- Figur 4:: eine erfindungsgemäßen Heizeinrichtung mit passiv betriebenen Heizelementen (keine Ausführungsform der Erfindung).

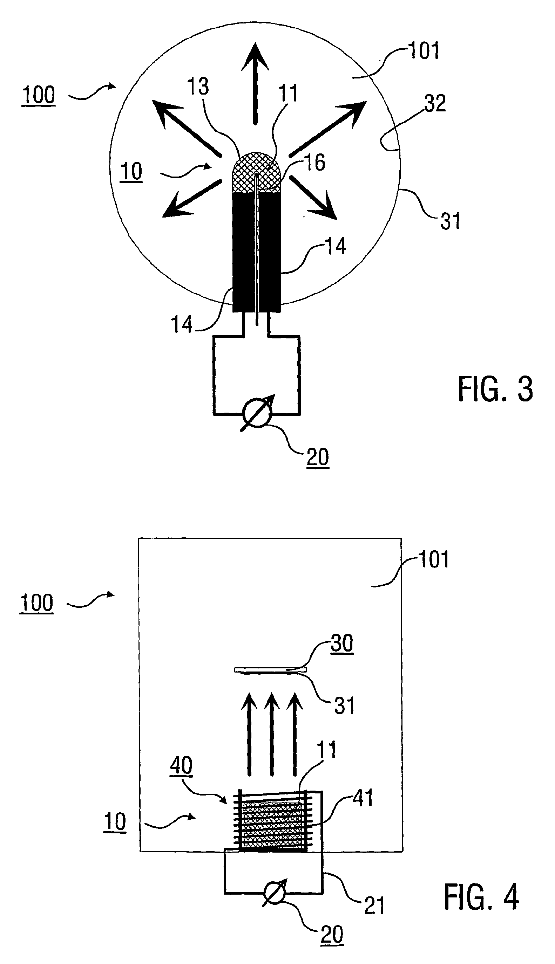

Ausführungsformen der Erfindung werden im Folgenden unter beispielhaftem Bezug auf die Verwendung von Heizkörpern mit einer konvexen Austrittsfläche beschrieben. Es wird betont, dass die Erfindung mit abgewandelten Formen der Austrittsfläche und/oder der gegenseitigen Anordnung der Heizeinrichtung relativ zu einem zu beschichtenden Substrat in die Praxis umsetzbar ist. Merkmale von Beschichtungsanlagen oder Verdampfern und deren Betrieb, soweit diese von herkömmlichen Verdampfungstechniken bekannt sind oder vom Fachmann an die Anwendung der erfindungsgemäßen Heizeinrichtung angepasst werden können, werden im Folgenden nicht gesondert erläutert. Beispielsweise kann bei allen Ausführungsformen ein Temperatursensor vorgesehen sein, der in Figur 3 gezeigt ist.

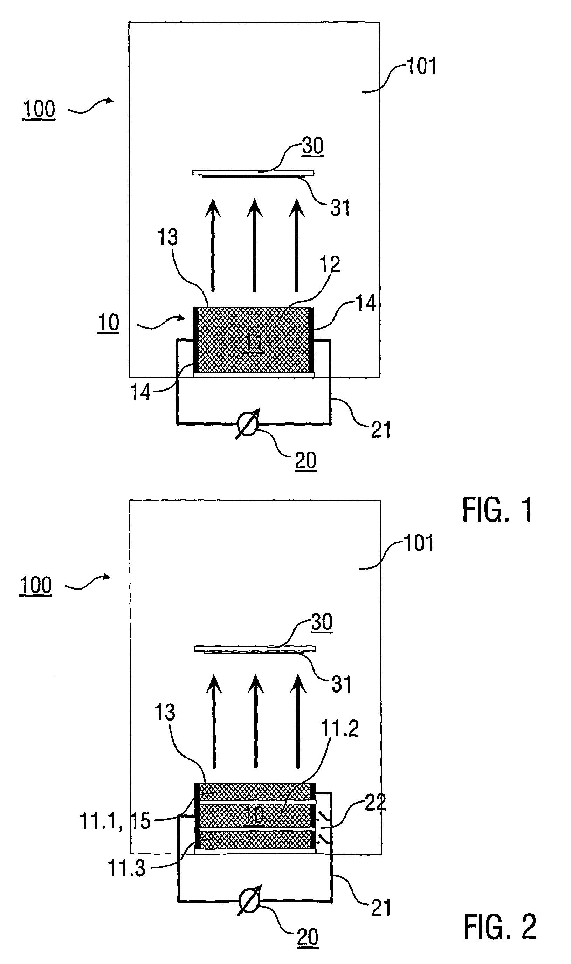

Figur 1 illustriert in schematischer Schnittansicht eine Beschichtungsanlage 100 mit einer Heizeinrichtung 10, einer externen Stromquelle 20 und einer Substrathalterung 30 (keine Ausführungsform der Erfindung). Der Innenraum der Beschichtungsanlage 100 ist eine an sich bekannte Abscheidekammer 101, die mit einer Vakuumeinrichtung (nicht dargestellt) evakuiert oder mit einer Inertgasquelle (nicht dargestellt) mit einem Trägergas gefüllt ist.

Die Heizeinrichtung 10 umfasst einen Heizkörper 11 aus einem festen Material mit offenen Poren. Der Heizkörper 11 besteht aus Siliziumkarbid mit einer mittleren Porengröße von ungefähr 1 mm. Diese Porengröße ist beispielsweise für die Verdampfung von organischen Farbstoffen, wie z. B. von Phthalocyaninen, oder ähnlichen Beschichtungsmaterialien geeignet. Das schematisch illustrierte Material des Heizkörpers 11 bildet die Heizelemente 12, zwischen denen das zu verdampfende Beschichtungsmaterial angeordnet werden kann. Der Heizkörper 11 weist eine ebene Austrittsfläche 13 auf, deren Form entsprechend der ebenen Form eines Substrates 31 auf der Substrathalterung 30 gewählt ist.

Der Heizkörper 11 weist seitliche Kontaktflächen 14 auf, die über elektrische Leitungen 21 mit der Stromquelle 20 verbunden sind. Die Stromquelle 20 umfasst bspw. eine Gleichstromquelle, mit der bei einer Betriebsspannung von z. B. 20 V ein Heizstrom von 2 A durch den Heizkörper 11 geleitet werden kann.

Der Heizkörper 11 besitzt die Form eines Quaders mit einer Höhe von z. B. 1 cm und Seitenlängen von z. B. 5 cm. Der Abstand der Austrittsfläche 13 vom Substrat 31 beträgt bspw. 5 cm.

Die Beschichtung des Substrats 31 umfasst die folgenden Prozessschritte. Erstens wird der Heizkörper 11 mit dem zu verdampfenden Beschichtungsmaterial beladen. Hierzu wird der Beschichtungskörper 11 an einer Beladestation (nicht dargestellt) bereitgestellt. Das zu verdampfende Beschichtungsmaterial wird auf die Oberfläche des Heizkörpers 11, z. B. auf die Austrittsfläche 13 aufgebracht. Je nach der Porengröße rieselt das Beschichtungsmaterial in das Volumen des Heizkörpers 11 ein. Das Rieseln kann durch eine Vibration des Heizkörpers 11 unterstützt werden. Feste Beschichtungsmaterialien können alternativ als flüssige Dispersion durch Eintropfen oder Übergießen in den Heizkörper 11 eingebracht werden. Bei der Verdampfung flüssiger Beschichtungsmaterialien wird der Heizkörper 11 an der Beladungsstation in die flüssige Phase des Beschichtungsmaterials eingetaucht und/oder mit dieser übergossen, so dass das Beschichtungsmaterial in den Heizkörper 11 eingesogen wird. Alternativ kann der Heizkörper 11 in der Abscheidekammer 101 beladen werden.

Anschließend wird die Stromquelle 20 betätigt. Bei Beaufschlagung mit elektrischem Strom wirkt der Heizkörper 11 als Widerstandsheizung, durch welche die Temperatur des Beschichtungsmaterials bis zur Verdampfung erhöht wird. Die Temperatur kann mit einem Temperatursensor (siehe Fig. 3) oder, wenn ein definierter Zusammenhang zwischen der Temperatur und dem elektrischen Widerstand des Heizkörpers 11 gegeben ist, durch eine Widerstandsmessung erfasst und ggf. mit einem Regelkreis auf den gewünschten Wert eingestellt werden. Die hohe Wärmeleitfähigkeit des Heizkörpers und dessen innere verzweigte Struktur gewährleisten eine homogene Temperaturverteilung im Heizkörper. Die direkte Wärmeerzeugung am Ort des Beschichtungsmaterials ermöglicht einen unmittelbaren, trägheitsfreien Eingriff in den Verdampfungsprozess. Das erwärmte Beschichtungsmaterial geht im Heizkörper in die gasförmige Phase über. Durch mehrfache Adsorption und Desorption gelangt das Beschichtungsmaterial durch die Austrittsfläche 13 nach außen, wo der weitere Materialfluss (Pfeile) zum Substrat 31 führt. Die eingestellte Temperatur liegt zum Beispiel im Bereich von 50 °C bis 600 °C oder darüber.

Abweichend von der quaderförmigen Geometrie für einen Flächenverdampfer kann das in Figur 1 illustrierte Prinzip mit einer linienförmigen Austrittsfläche (Linear- oder Schlitz-Verdampfer) oder einer nahezu punktförmigen Austrittsfläche (Quasi-Punkt-Verdampfer) realisiert werden.

Figur 2 illustriert in schematischer Schnittansicht eine Beschichtungsanlage 100, bei der abweichend von der Gestaltung gemäß Figur 1 mehrere Heizkörper 11.1, 11.2, 11.3 vorgesehen sind (keine Ausführungsform der Erfindung). Durch eine Schalteinrichtung 22 können die einzelnen Heizkörper 11.1, 11.2, 11.3 im Verdampfungsprozess nach einem bestimmten Operationsschema, zum Beispiel sequentiell eingeschaltet werden. Diese Betriebsart hat den Vorteil, dass die Heizkörper mit einer großen Menge von Verdampfungsmaterial beladen werden können, die schrittweise durch das Einschalten der Heizkörper freigesetzt wird. Wenn der oberste Heizkörper 11.1 durch die Verdampfung entladen worden ist, bildet er für die weitere Verdampfung eine Lenkeinrichtung 15 zur Ausrichtung des Materialflusses hin zum Substrat 31.

Figur 3 illustriert schematisch die erfindungsgemäße Beschichtung von konkaven Oberflächen. Beim dargestellten Beispiel ist das Substrat 31 eine Hohlkugel, deren innere Oberfläche 32 homogen beschichtet werden soll. Der Innenraum der Hohlkugel bildet die Abscheidekammer 101, die evakuiert oder mit einem Inertgas gefüllt sein kann.

Der Heizkörper 11 der Heizeinrichtung 10 besteht aus einer offenporig geschäumten, elektrisch leitfähigen Keramik, z. B. Siliziumkarbid, die inert gegenüber den zu verdampfenden Beschichtungsmaterialien ist. Die Austrittsfläche 13 des Heizkörpers 11 ist konvex als Oberfläche einer Halbkugel oder als Oberfläche einer Zusammensetzung aus einer Halbkugel und einem Kreiszylinder gebildet.

Auf der Unterseite des Heizkörpers 11 sind zwei voneinander elektrisch isolierte Kontaktbereiche 14 angebracht, die der Beaufschlagung des Heizkörpers 11 mit elektrischem Strom und gleichzeitig der mechanischen Halterung des Heizkörpers 11 in der Mitte der Hohlkugel dienen. Des Weiteren ist ein Temperatursensor 16 vorgesehen, mit dem die Einstellung der Temperatur im Heizkörper 11 überwacht und der zur Steuerung des Verdampfungsprozesses verwendet werden kann. Die Kontaktbereiche 14 sind über eine Schalteinrichtung (nicht dargestellt) mit der Stromquelle 20 verbunden.

Der Verdampfungsvorgang erfolgt analog zu den oben beschriebenen Prozessschritten. Nach der Beladung des Heizkörpers 11 erfolgt die Widerstandsheizung und Temperatureinstellung derart, dass das Beschichtungsmaterial allseits von der Austrittsfläche 13 (siehe Pfeile) auf die innere Oberfläche 32 des Substrats 31 bewegt wird. Durch die innere Struktur des Heizkörpers 11 wird ein homogener Materialfluss in alle Richtungen gewährleistet. Wenn in der Hohlkugel ein Inertgasdruck eingestellt wird, kann durch die Streuung des verdampften Materials an den Gasmolekülen die Homogenität der Beschichtung auf der Oberfläche 32 erhöht werden.

Figur 4 illustriert die Verwendung von indirekt geheizten Heizelementen (keine Ausführungsform der Erfindung). In der Abscheidekammer 101 der Beschichtungsanlage 100 ist die Heizeinrichtung 10 mit dem Heizkörper 11 angeordnet. Der Heizkörper 11 ist thermisch mit einer Wärmequelle 40 in Form eines spiralförmig umlaufenden Filaments 41 verbunden, das über elektrische Leitungen 21 mit einer Stromquelle 20 mit elektrischem Strom beaufschlagt werden kann. In der Abscheidekammer 101 ist des Weiteren die Substrathalterung 30 für ein zu beschichtendes Substrat 31 vorgesehen. Im Unterschied zu den oben beschriebenen Varianten wird der Heizkörper 11 bei der in Figur 4 gezeigten Variante mit einem Wärmestrom beaufschlagt, der zur Einstellung der Verdampfungstemperatur des Beschichtungsmaterials im Heizkörper 11 dient. Die Verdampfung erfolgt entsprechend den oben beschriebenen Prozentschritten.

Die in der Beschreibung, den Zeichnungen und den Ansprüchen offenbarten Merkmale der Erfindung können einzeln oder in Kombination für die Verwirklichung der Erfindung in ihren verschiedenen Ausgestaltungen von Bedeutung sein.

## Patentansprüche

1. Verfahren zur Überführung von Beschichtungsmaterial in einer Beschichtungsanlage (100) in die Gasphase und zur Beschichtung eines Substrates (31), mit den Schritten:
- Beladung von einem Heizkörper (11) einer Heizeinrichtung (10) mit dem Beschichtungsmaterial, wobei der Heizkörper (11) Hohlräume, eine innere Oberfläche und eine Vielzahl von verteilt angeordneten Heizelementen (12) aufweist und die Hohlräume des Heizkörpers (11) mit dem Beschichtungsmaterial beladen werden,
- Betätigung der Heizelemente (12) des mindestens einen Heizkörpers, und
- Abscheidung des in die Gasphase überführten Beschichtungsmaterials auf dem Substrat (31),
**dadurch gekennzeichnet, dass**
- die Hohlräume des Heizkörpers (11) durch offenporigen Schaum gebildet werden,
- das Substrat eine konkave Oberfläche (32) aufweist, und
- eine Austrittsfläche (13) des Heizkörpers (11) und/oder einer Lenkeinrichtung (15), mit der die Heizeinrichtung (10) ausgestattet ist, konvex ausgebildet ist, so dass eine Strahlcharakteristik des in die Gasphase überführten Beschichtungsmaterials geformt und die konkave Oberfläche (32) des Substrates homogen beschichtet wird.

2. Verfahren nach Anspruch 1, bei dem die Betätigung der Heizelemente (12) eine Beaufschlagung der Heizelemente (12) mit elektrischem Strom oder einem Wärmestrom umfasst.

3. Verfahren nach Anspruch 2, bei dem die Heizelemente (12) eine Wärmeleitfähigkeit von mindestens 2 W/m·K aufweisen und die Betätigung der Heizelemente eine Beaufschlagung der Heizelemente mit einem Wärmestrom umfasst.

4. Verfahren nach mindestens einem der vorhergehenden Ansprüche, bei dem
- die Heizelemente (12) in den Heizkörper (11) eingebettet sind, oder
- die Heizelemente (12) durch Innenwände des Heizkörpers (11) gebildet sind.

5. Verfahren nach mindestens einem der vorhergehenden Ansprüche, bei dem
- die Heizelemente (12) zur unmittelbaren Umwandlung von elektrischer Energie in thermische Energie eingerichtet sind.

6. Verfahren nach mindestens einem der vorhergehenden Ansprüche, bei dem
- die Heizelemente (12) mit mindestens einer Wärmequelle (40) verbunden sind.

7. Verfahren nach mindestens einem der vorhergehenden Ansprüche, bei dem
- der Heizkörper (11) aus einem Metall, einer Keramik oder einer Metall-Keramik-Zusammensetzung gebildet ist.

8. Verfahren nach mindestens einem der vorhergehenden Ansprüche, bei dem
- die Hohlräume in mindestens einer Dimension eine charakteristische Größe im Bereich von 1 mm bis 5 cm aufweisen.

9. Verfahren nach mindestens einem der vorhergehenden Ansprüche, bei dem
- die Hohlräume in mindestens einer Dimension eine charakteristische Größe im Bereich von 1 µm bis 1 mm aufweisen.

10. Verfahren nach mindestens einem der vorhergehenden Ansprüche, bei dem
- das Beschichtungsmaterial organisches Material umfasst.

## Claims

1. Method for the transfer of coating material in a coating installation (100) into the gas phase and for coating a substrate (31), with the steps:
- loading of a heating body (11) of a heating device (10) with the coating material, wherein the heating body (11) has hollow spaces, an inner surface and a plurality of distributively arranged heating elements (12) and the hollow spaces of the heating body (11) are loaded with the coating material,
- activation of the heating elements (12) of the at least one heating body, and
- deposition of the coating material transferred into the gas phase on the substrate (31),
**characterized in that**
- the hollow spaces of the heating body (11) are formed by open-pore foam,
- the substrate as a concave surface (32), and
- an outlet surface (13) of the heating body (11) and/or a guiding apparatus (15), with which the heating device (10) is provided, is convex, so that a beam characteristic of the coating material transferred into the gas phase is formed and the concave surface (32) of the substrate is homogeneously coated.

2. Method according to claim 1, wherein the activation of the heating elements (12) comprises applying an electrical current or a thermal current to the heating elements (12).

3. Method according to claim 2, wherein the heating elements (12) have a thermal conductivity of at least 2 W/m K and the activation of the heating elements comprises an application of a thermal current to the heating elements.

4. Method according to at least one of the preceding claims, wherein
- the heating elements (12) are embedded in the heating body (11), or
- the heating elements (12) are formed by inner walls of the heating body (11).

5. Method according to at least one of the preceding claims, wherein
- the heating elements (12) are set up for an immediate conversion of electric energy into thermal energy.

6. Method according to at least one of the preceding claims, wherein
- the heating elements (12) are connected to at least one thermal source (40).

7. Method according to at least one of the preceding claims, wherein
- the heating body (11) is formed from a metal, a ceramic material or a metal-ceramic compound.

8. Method according to at least one of the preceding claims, wherein
- the hollow spaces in at least one dimension have a characteristic size in the range of 1 mm to 5 cm.

9. Method according to at least one of the preceding claims, wherein
- the hollow spaces in at least one dimension have a characteristic size in the range of 1 µm to 1 mm.

10. Method according to at least one of the preceding claims, wherein
- the coating material comprises organic material.

## Revendications

1. Procédé pour la conversion en phase gazeuse d'un matériau de revêtement dans une installation de revêtement (100) et pour le revêtement d'un substrat (31), comprenant les phases suivantes :
- chargement du matériau de revêtement dans un corps de chauffe (11) d'un dispositif de chauffage (10), le corps de chauffe (11) comportant des cavités, une surface interne et une pluralité d'éléments de chauffe (12) répartis, et les cavités du corps de chauffe (11) étant chargées avec le matériau de revêtement,
- activation des éléments de chauffe (12) du ou des corps de chauffe, et
- séparation sur le substrat (31) du matériau de revêtement passé en phase gazeuse,
**caractérisé en ce que**
- les cavités du corps de chauffe (11) sont formées par une mousse à pores ouverts,
- le substrat présente une surface concave (32), et
- une surface de sortie (13) du corps de chauffe (11) et/ou un dispositif de guidage (15) dont le dispositif de chauffage (10) est équipé, sont prévus avec une convexité, de manière à former une caractéristique de jet du matériau de revêtement passé en phase gazeuse et à revêtir de manière homogène la surface concave (32) du substrat.

2. Procédé selon la revendication 1, où l'activation des éléments de chauffe (12) comprend une application de courant électrique ou d'un courant thermique sur les éléments de chauffe (12).

3. Procédé selon la revendication 2, où les éléments de chauffe (12) présentent une conductivité thermique minimale de 2 W/m•K et où l'activation des éléments de chauffe comprend une application d'un courant thermique sur les éléments de chauffe.

4. Procédé selon au moins une des revendications précédentes, où
- les éléments de chauffe (12) sont incorporés au corps de chauffe (11), ou
- les éléments de chauffe (12) sont formés par des parois internes du corps de chauffe (11).

5. Procédé selon au moins une des revendications précédentes, où
- les éléments de chauffe (12) sont prévus pour une conversion instantanée de l'énergie électrique en énergie thermique.

6. Procédé selon au moins une des revendications précédentes, où
- les éléments de chauffe (12) sont reliés à au moins une source de chaleur (40).

7. Procédé selon au moins une des revendications précédentes, où
- le corps de chauffe (11) est en métal, en céramique ou en composite métal-céramique.

8. Procédé selon au moins une des revendications précédentes, où
- les cavités ont une grandeur caractéristique comprise entre 1 mm et 5 cm dans au moins une dimension.

9. Procédé selon au moins une des revendications précédentes, où
- les cavités ont une grandeur caractéristique comprise entre 1 µm et 1 mm dans au moins une dimension.

10. Procédé selon au moins une des revendications précédentes, où
- le matériau de revêtement comprend de la matière organique.
